# EUROPÄISCHE PATENTSCHRIFT

(11) **EP 3 191 852 B1**
(45) Veröffentlichungstag und Bekanntmachung des Hinweises auf die Patenterteilung: **06.03.2024**
(21) Anmeldenummer: 15787126.0
(22) Anmeldetag: 02.09.2015
(51) Int. Cl.: G01R 1/22, G01R 15/20

(54) **STROMMESSZANGE**
CLIP-ON AMMETER
PINCE AMPÉROMÉTRIQUE

(30) Priorität: 04.09.2014 DE 202014007077 U
(43) Veröffentlichungstag der Anmeldung: 19.07.2017
(73) Patentinhaber: Infineon Technologies AG, 85579 Neubiberg (DE)
(72) Erfinder: ZÖPPIG, Veit, 98704 Langewiesen (DE)
(74) Vertreter: Infineon Patent Department
(86) Internationale Anmeldenummer: PCT/DE2015/000436
(87) Internationale Veröffentlichungsnummer: WO 2016/034162

(56) Entgegenhaltungen:
- EP-A2- 2 602 922
- DE-U1-202009 014 382
- US-A- 5 168 435
- US-A1- 2020 209 319

## Beschreibung

Die Erfindung betrifft eine Strommesszange zur Erfassung von Stromwerten in einem elektrischen Leiter.

Strommesszangen sind aus dem Stand der Technik bereits in unterschiedlichen Ausführungsformen bekannt, wobei eine indirekte Messung des Stroms, insbesondere über die Erfassung eines, sich um einen elektrischen Leiter ausbildenden, statischen oder wechselnden Magnetfeldes durchgeführt wird.

Eine Ausführungsform stellen hierbei beispielsweise sogenannte Strommesszangenmultimeter dar, welche einen anliegenden Strom als analogen Messwert erfassen und diesen in der Regel als digitalen Wert über eine integrierte Anzeigevorrichtung, insbesondere ein Display, ausgeben.

Darüber hinaus sind Strommesszangen zum Anschluss an Oszilloskope bekannt, welche ebenfalls einen anliegenden Strom als analogen Messwert erfassen, diesen jedoch nicht unmittelbar ausgeben können.

Die Ausgabe des jeweiligen Messwertes erfolgt in diesem Fall über das anzuschließende Oszilloskop.

Der entscheidende Nachteil derartiger Strommesszangen zum Anschluss an Oszilloskope liegt jedoch insbesondere darin, dass die jeweilige Strommesszange zu dem verwendeten Oszilloskop kompatibel sein muss und so eine universelle Verwendung einer Strommesszange an verschiedenen Oszilloskopen in der Regel nicht bereitstellbar ist.

Zudem weisen die genannten Strommesszangenmultimeter und Strommesszangen zum Anschluss an Oszilloskope den Nachteil auf, dass diese eine Energieversorgung benötigen, durch welche die integrierte Mess- und Umwandlungselektronik, insbesondere zur Verstärkung von erfassbaren, statischen Magnetfeldsignalen, versorgt wird. Diese Energieversorgung wird dabei in der Regel durch externe Geräte, bei einem Anschluss einer Strommesszange an ein Oszilloskop unter Umständen bei geeigneten Oszilloskopen durch das Oszilloskop selbst mittels gerätespezifischer Steckersysteme, oder durch in die jeweilige Strommesszange integrierte Energiequellen, beispielsweise eine Batterie, bereitgestellt.

Ein weiterer Nachteil derartiger Strommesszangen liegt darüber hinaus darin, dass diese, in Abhängigkeit der bereitstellbaren Genauigkeit, sehr teuer sind. Ferner sind aus dem Stand der Technik auch Strommesszangen bekannt, welche ohne eine zusätzliche Energieversorgung auskommen. Derartige Strommesszangen sind jedoch nur dazu in der Lage, Messwerte von Wechselströmen, aufgrund der sich einstellenden Wechselfelder, zu erfassen. Messwerte von Gleichströmen können durch die genannten Strommesszangen nicht erfasst werden.

Aus der Gebrauchsmusterschrift DE 20 2009 014 382 U1 ist zudem eine Strommessvorrichtung bekannt, welche eine USB-Schnittstelle zur Energieversorgung der Messeinheit und zur Datenübertragung an ein Auswertegerät aufweist.

Der Nachteil der hier offenbarte Lösung begründet sich insbesondere darin, dass über die über die USB-Schnittstelle anliegende Spannung nach dem USB-Standard von ca. 5 V nur bedingt stabil ist und bei der Verwendung als Referenzspannung für Gleichstrommessungen zu Messergebnissen von geringerer Genauigkeit führt. Das Dokument EP2233933 A2 offenbart eine Strommessvorrichtung mit eingebauter Batterie und Spannungswandlern zur Konvertierung ihrer Spannung.

Die Aufgabe der vorliegenden Erfindung ist es daher, unter Vermeidung der Nachteile des Standes der Technik, eine universell verwendbare Strommesszange bereitzustellen, mit welcher Messwerte, sowohl von Wechsel- als auch von Gleichströmen erfassbar sind und welche darüber hinaus eine hohe Genauigkeit aufweist und welche, ohne separate Energieversorgung insbesondere eine präzise Erfassung von Gleichstrommesswerten ermöglicht und welche gleichzeitig kostengünstig bereitstellbar ist.

Die Aufgabe wird durch die im Patentanspruch 1 aufgeführten Merkmale gelöst. Bevorzugte Weiterbildungen ergeben sich aus den Unteransprüchen.

Eine erfindungsgemäße Strommesszange weist eine Stromerfassungseinheit, eine Auswertungseinheit sowie eine USB-Schnittstelle auf. Zudem weist die Strommesszange zusätzliche Komponenten wie beispielsweise einen teilbaren Kern auf, welche jedoch den üblichen Komponenten bekannter Strommesszangen entsprechen und daher nachfolgend nicht näher erläutert werden.

Die Stromerfassungseinheit ist vorliegend dazu in der Lage, Stromwerte in einem Stromkreis zu erfassen und die erfassten Stromwerte als Messwerte übertragbar bereitzustellen.

Die Stromerfassungseinheit ist beispielsweise als Hall-Sensor ausgebildet, wobei die technischen Vorgänge während der Erfassung der Stromwerte, insbesondere die Umfassung des jeweiligen elektrischen Leiters und das Erfassen des, um den elektrischen Leiter herum auftretenden, Magnetfeldes der Wirkweise herkömmlicher Strommesszangen entsprechen und daher an dieser Stelle als bekannt vorausgesetzt und nicht detailliert ausgeführt werden.

Bei den, durch die Stromerfassungseinheit übertragbar bereitstellbaren, Messwerten handelt es sich insbesondere um analoge Messwerte.

Die erfindungsgemäß vorgesehene Auswertungseinheit ist zum einen mit der Stromerfassungseinheit verbunden. Sie ist dazu in der Lage, die durch die Stromerfassungseinheit übertragbar bereitgestellten Messwerte zu erfassen und zu verarbeiten. Hierzu weist die Auswertungseinheit vorliegend einen Analog-Digital-Wandler, nachfolgend auch als A/D-Wandler beschrieben, auf, mittels dessen die analogen Messwerte der Stromerfassungseinheit in digitale Messwerte umwandelbar sind.

Ferner ist die Auswertungseinheit mit der USB-Schnittstelle verbunden.

Ein wesentliches Merkmal der vorliegenden Strommesszange besteht insbesondere darin, dass die Auswertungseinheit zusätzlich dazu in der Lage ist, die digitalen Messwerte als USB-kompatible Daten bereitzustellen, wobei die USB-kompatiblen Daten von der Auswertungseinheit an die USB-Schnittstelle übertragbar sind.

Hierbei werden die digitalen Messwerte gemäß einem entsprechenden USB-Datenprotokoll spezifiziert.

Mittels der USB-Schnittstelle werden erfindungsgemäß die USB-kompatiblen Daten für eine externe Weiterverarbeitung übertragbar bereitgestellt.

Weiterhin besteht ein wesentliches Merkmal darin, dass über die Verbindung von Auswertungseinheit und USB-Schnittstelle auch eine Spannungsversorgung der Auswertungseinheit mittels der USB-Schnittstelle zur Verfügung gestellt wird.

In diesem Zusammenhang bildet die USB-Schnittstelle einen elektrisch/mechanischen Standard für eine Verbindungseinheit, über welche die aufgezeigte Strommesszange mit einer externen Datenverarbeitungseinheit verbindbar ist und mittels derer die USB-kompatiblen Daten von der Strommesszange auf die jeweils angeschlossene, externe Datenverarbeitungseinheit übertragbar sind und zugleich eine Energieversorgung der Auswertungseinheit realisierbar ist.

Als besonderer Vorteil können als externe Datenverarbeitungseinheiten alle USB-fähigen Datenverarbeitungseinheiten mit entsprechender Datenverarbeitungssoftware eingesetzt werden; es werden vorzugsweise tragbare Geräte wie beispielsweise Laptop, Tablet oder Smartphone eingesetzt, welche über eine entsprechende Datenverarbeitungssoftware verfügen und durch welche sowohl eine Anzeige als auch eine Verarbeitung und Speicherung der USB-kompatiblen Daten der Strommesszange bereitstellbar ist. Derartige, tragbare Geräte werden in der Regel von einer messenden Person, beispielsweise einem Elektroinstallateur ohnehin während seiner Tätigkeiten mitgeführt, woraus sich der besondere Vorzug der Strommesszange ergibt, dass über die ohnehin mitgeführten Geräte keine zusätzlichen Einrichtungen zur Anzeige und Verarbeitung/Speicherung der durch die Strommesszange erfassten Messwerte eingesetzt werden müssen.

Gleichzeitig wird über die USB-Schnittstelle besonders vorteilhaft die Energieversorgung der Auswertungseinheit bereitgestellt, wobei die notwendige Versorgungsenergie der Auswertungseinheit durch die, an die USB-Schnittstelle anschließbare, externe Datenverarbeitungseinheit bereitgestellt und über die USB-Schnittstelle auf die Auswertungseinheit übertragen wird.

Beispielsweise wird gemäß dem gängigen USB 2.0-Standard eine stabilisierte Spannung von 5V± 5% sowie ein Strom von bis zu 500 mA durch die USB-Schnittstelle bereitgestellt.

Die vorliegende Strommesszange weist erfindungsgemäß einen Spannungswandler auf, welcher der USB-Schnittstelle zugeordnet ist und von der über die USB-Schnittstelle anliegenden Spannung gespeist wird.

Der Spannungswandler ist hierbei dazu in der Lage, eine stabilisierte Spannung als Referenzspannung für die Stromerfassungseinheit bereitzustellen.

Dem liegt zu Grunde, dass für einen Gleichstrommessung die Stromerfassungseinheit als Hall-Sensor aufgebildet ist, welcher mit einer Referenzspannung zu versorgen ist. Da eine direkte Beziehung zwischen der Referenzspannung und dem an einem Hall-Sensor anliegenden Messwert besteht, ermöglicht die hohe Konstanz der stabilisierten Spannung, beziehungsweise des resultiernden Stromes, eine hohe Messgenauigkeit einer Gleichstrommessung.

Einen weiteren Vorteil bildet es, dass eine zuverlässige Bereitstellung einer Referenzspannung gesichert ist, ohne dass es zusätzlicher Konstantquellen wie einer Batterie, eines Akkus oder separater Referenzspannungsquellen bedarf. Insbesondere kann zum einen auf ein sonst notwendiges Überwachen des Ladezustandes und auf ein Nachladen des Akkus oder ein Ersetzen einer entleerten Batterie verzichtet werden; die Strommesszange liegt damit stets betriebsfähig vor. Ferner wird ein bei Akkus oder Batterien, bei Annäherung an den Entladungszustand, auftretender Abfall der Referenzspannung und eine damit einhergehende Messungenauigkeit der Stromerfassungseinheit oder das Erfordernis einer Nachjustierung vermieden.

Die erfindungsgemäße Strommesszange weist somit die besonderen technologischen Vorteile auf, dass diese zum einen mittels der USB-Schnittstelle universell mit jeder USB-fähigen, externen Datenverarbeitungseinheit verbindbar ist und dass zum anderen die notwendige Energieversorgung der Auswertungseinheit ebenfalls über die USB-Schnittstelle sichergestellt wird sowie dass mittels des Spannungswandlers eine stabilisierte Referenzspannung für die Stromerfassungseinheit bereitgestellt und somit eine präzise Erfassung der Messwerte von Gleichströmen ermöglicht wird. Zusätzliche Einrichtungen zur Energieversorgung der Auswertungseinheit oder zur Bereitstellung der stabilen Referenzspannung, wie beispielsweise Batterien oder externe Quellen über gerätespezifische oder zusätzliche Verbindungsleitungen, sind somit verzichtbar.

Zudem kann eine erfindungsgemäße Strommesszange, insbesondere aufgrund der entfallenden Zusatzeinrichtungen, besonders preisgünstig bereitgestellt und gleichzeitig durch den Verzicht auf Batterien, auch die Umweltbelastung gesenkt werden.

In einer bevorzugten Weiterbildung der erfindungsgemäßen Strommesszange ist die Stromerfassungseinheit als intelligenter Messchip ausgebildet und insbesondere dazu in der Lage, erfasste Stromwerte aufzubereiten und die aufbereiteten Stromwerte als Messwerte übertragbar bereitzustellen.

Als intelligenter Messchip ist ein Messchip zu verstehen, welcher eine Linearisierung einer Messkennlinie der bereitzustellenden Messwerte und eine Fehlerkompensation, insbesondere für Temperatureinflüsse oder Betriebsspannungsänderungen, durchführen kann.

Der intelligente Messchip kann optional zusätzliche Leistungsmerkmale aufweisen. Ein solches zusätzliches Leistungsmerkmal kann darin bestehen, dass der intelligente Messchip, beispielsweise mithilfe der externen Datenverarbeitungseinheit, parametrisiert werden kann, was bedeutet, dass zum Beispiel eine MessEmpfindlichkeit oder ein Offset des intelligenten Messchips eingestellt werden können oder dass eine zusätzliche Fehlerkompensation äußerer Fehlerquellen oder -einflüsse wie beispielsweise Montage- oder Toleranzungenauigkeiten mittels der externen Datenverarbeitungseinheit durchführbar ist.

In der hier aufgezeigten Weiterbildung weist die Stromerfassungseinheit vorzugsweise eine separate Verbindung zu der USB-Schnittstelle auf, wobei durch die Verbindung insbesondere eine Energieversorgung der Stromerfassungseinheit bereitstellbar ist.

Alternativ kann die Energieversorgung der Stromerfassungseinheit auch mittelbar über die Auswertungseinheit erfolgen.

Die Ausbildung der Stromerfassungseinheit als intelligenter Messchip bietet insbesondere den technologischen Vorteil, dass bereits in dem Messchip eine Aufbereitung der ermittelten Messwerte durchgeführt werden kann und somit die Auswertungseinheit von diesen Verarbeitungsvorgängen entlastet wird.

Die nachfolgende Verarbeitung der Messwerte in der Auswertungseinheit kann somit einfacher und vor allem stromsparender durchgeführt werden, sodass der resultierende Energiebedarf der erfindungsgemäßen Strommesszange gemäß dieser bevorzugten Weiterbildung besonders gering ist.

Als besonderer Vorteil kann die Energieversorgung der erfindungsgemäßen Strommesszange gemäß dieser bevorzugten Weiterbildung auch durch kleinere transportable USB-fähige Datenverarbeitungsgeräte, wie beispielsweise ein Smartphone, bereitgestellt sowie längere Zeit aufrecht erhalten werden.

Durch die erfindungsgemäß bereitstellbare Parametrisierbarkeit des Messchips können als weiterer Vorteil durch den Hersteller der Strommesszange eine produktspezifische Einstellung der Messempfindlichkeit des Messchips bereitgestellt und so, je nach Auslegung der Strommesszange, unterschiedliche Messgenauigkeiten und/oder Messbereiche vorgegeben werden.

Darüber hinaus sieht eine bevorzugte Variante der Erfindung vor, dass die Strommesszange einen Energiepufferspeicher zum temporären Zwischenspeichern der Energie zur Versorgung der Auswertungseinheit aufweist.

Der Energiepufferspeicher wird erfindungsgemäß durch die, an die USB-Schnittstelle angeschlossene, externe Datenverarbeitungseinheit und über die USB-Schnittstelle mit Energie versorgt, wobei über die USB-Schnittstelle wahlweise nur die Energieversorgung des Energiepufferspeichers oder parallel die Energieversorgung des Energiepufferspeichers und der Auswertungseinheit bereitgestellt wird.

Zudem ist die Energieversorgung der Auswertungseinheit auch allein durch den Energiepufferspeicher bereitstellbar.

Generell sind bei der vorliegenden Variante zwei Betriebszustände für die Energieversorgung bereitstellbar.

Der erste Betriebszustand sieht vor, dass über die externe Datenverarbeitungseinheit mittels der USB-Schnittstelle die Energieversorgung erfolgt. Vorzugsweise kann die USB-Schnittstelle sowohl die Energieversorgung des Energiepufferspeichers als auch parallel die Energieversorgung der Auswertungseinheit übernehmen. In diesem Fall erfolgt neben der eigentlichen Energieversorgung der Auswertungseinheit ein paralleles Aufladen des Energiepufferspeichers. Je nach Leistung der externen Datenverarbeitungseinheit kann auch statt einer Parallelversorgung von Auswertungseinheit und Energiepufferspeicher eine zeitlich versetzte Versorgung erfolgen, wozu vorzugsweise dem Energiepufferspeicher noch eine Energiemanagementeinheit zugeordnet sein kann.

In dem zweiten Betriebszustand kann durch den aufgeladenen Energiepufferspeicher die Energieversorgung der Auswertungseinheit auch dann aufrecht erhalten werden, wenn die Energieversorgung nicht durch die externe Datenverarbeitungseinheit mittels der USB-Schnittstelle bereitgestellt wird.

Zudem weist die Strommesszange in der vorliegenden Variante einen Datenspeicher auf, mit welchem die digitalen Messwerte der Auswertungseinheit temporär speicherbar und übertragbar bereitstellbar sind.

Der Datenspeicher ist erfindungsgemäß mit der Auswertungseinheit verbunden, sodass die digitalen Daten bei Bedarf durch die Auswertungseinheit auf dem Datenspeicher ablegbar und nach Wiederherstellung der USB-Verbindung wieder abrufbar sind.

Optional kann der Datenspeicher zusätzlich direkt mit der USB-Schnittstelle verbunden sein, wobei die digitalen Werte vorzugsweise als USB-kompatible Daten auf dem Datenspeicher hinterlegt werden, sodass die externe Datenverarbeitungseinheit über die USB-Schnittstelle bei Bedarf direkt auf die USB-kompatiblen Daten des Datenspeichers zugreifen kann.

Die hier aufgezeigte Variante bietet insbesondere den technologischen Vorteil, dass die Strommesszange zeitweise autark, das bedeutet ohne externe Energieversorgung und ohne Übertragung der Messwerte an eine externe Datenverarbeitungseinheit, betrieben werden kann.

Auf diese Weise wird zum einen die Mobilität der Strommesszange zusätzlich verbessert, was besonders bei schwer zugänglichen oder auf hohem Potential liegenden Messstellen vorteilhaft ist. Zum anderen können eventuelle Engpässe bei der Bereitstellung der Energieversorgung oder einer funktionsbereiten externen Datenverarbeitung, welche beispielsweise bei einem vorübergehenden Ausfall der externen Datenverarbeitungseinheit auftreten können, temporär überbrückt werden.

In einer bevorzugten Weiterentwicklung weist die Strommesszange im Zusammenhang mit dem Energiespeicher eine Anzeigevorrichtung auf, mit welcher eine verbleibende Restnutzungsenergie, beziehungsweise eine Restnutzungsdauer angezeigt werden oder welche dazu in der Lage ist, bei Unterschreitung eines kritischen Wertes der Restnutzungsenergie ein entsprechendes Warnsignal auszugeben.

Eine weitere Variante der erfindungsgemäßen Strommesszange sieht darüber hinaus vor, dass diese zusätzlich eine Anzeigevorrichtung aufweist, über welche der ermittelte Stromwert, parallel zu dessen Weiterverarbeitung in der Auswertungseinheit, als digitaler Wert anzeigbar ist.

Ein erfindungsgemäßer Aspekt der Strommesszange sieht vor, dass diese eine Signalaufbereitungseinheit aufweist, welche mit der Stromerfassungseinheit verbunden ist und mit welcher die Messwerte als analoge Signale erfassbar und zu Analogdaten aufbereitbar sind. Die Aufbereitung der Messwerte erfolgt insbesondere durch eine Spannungsverstärkung und je nach Notwendigkeit durch eine Spannungsverschiebung, so dass eine gute grafische Darstellbarkeit mit hoher Auflösung, insbesondere mittels eines Oszilloskops ermöglicht wird.

Die Signalaufbereitungseinheit ist erfindungsgemäß mit dem Spannungswandler verbunden und wird durch diesen mit einer bipolaren Spannung von vorzugsweise +/- 5V gespeist.

Als weiteres Merkmal weist die erfindungsgemäße Strommesszange in der hier aufgeführten Weiterbildung einen Analogausgang auf, welcher mit der Signalaufbereitungseinheit verbunden ist und über welchen die Analogdaten ausgebbar sind

Mittels des Analogausgangs kann die Strommesszange als besonderer Vorteil mit einem Oszilloskop verbunden werden, über welches die Analogdaten anzeigbar sind.

Gegenüber herkömmlichen Lösungen, kann bei einer Anwendung der erfindungsgemäßen Strommesszange mit Spannungswandler in der vorliegenden Erfindung der gesamte Bereich von +/- 5V für eine analoge Ausgabe der Analogdaten verwendet werden.

Dies ermöglicht es somit als besonderen Vorteil, die Messwerte sowohl digital, wobei hier die Übertragung über die USB-Datenverbindung erfolgt, als auch analog, hier über den Analogausgang, auszugeben.

In einer bevorzugten Variante der Strommesszange ist zudem die Auswertungseinheit dazu in der Lage ein Steuersignal zur Nullsetzung bereitzustellen und dieses an die Signalaufbereitungseinheit zu übertragen. Dabei wird das Steuersignal insbesondere über einen in die Auswertungseinheit integrierten D/A-Wandler als analoges Signal bereitgestellt. Hierbei weisen die Auswertungseinheit einen Steuersignalausgang und die Signalaufbereitungseinheit einen Steuersignaleingang auf, wobei der Steuersignalausgang mit dem Steuersignaleingang verbunden ist. Die Erzeugung des Steuersignals wird vorzugsweise über eine Tastendruck oder mittels einer externen Datenverarbeitungseinheit über die USB-Datenverbindung in der Auswertungseinheit initialisiert Mittels des Steuersignals ist die Signalaufbereitungseinheit dazu in der Lage, eine Nullsetzung der Analogdaten auszuführen. Auf diese Weise wird insbesondere eine Kalibrierung des Analogausgangs der Strommesszange ermöglicht, so dass beispielsweise auf einem Oszilloskop eine Nulllinie dargestellt wird, wenn in dem zu messenden Leiter kein Strom fließt.

Die Erfindung wird nachfolgend in Ausführungsbeispielen anhand von
- Fig. 1: schematische Prinzipdarstellung mit Spannungswandler
- Fig. 2: schematische Prinzipdarstellung mit Spannungswandler und durchgeschliffener Spannungsversorgung
- Fig. 3: schematische Prinzipdarstellung mit Analogausgang
- Fig. 4: schematische Prinzipdarstellung mit Energiepufferspeicher und Datenspeicher näher erläutert.

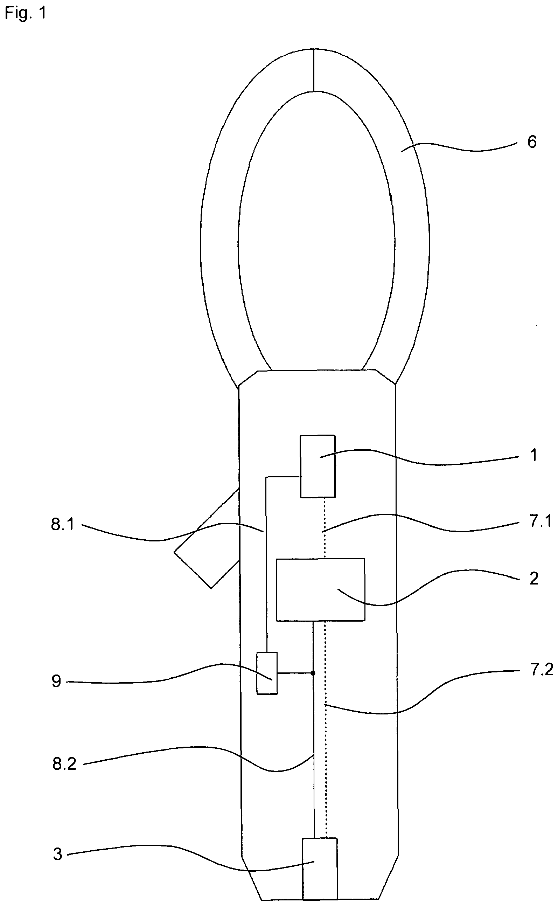

Fig. 1 zeigt eine Prinzipdarstellung einer Strommesszange mit einem Spannungswandler (9).

In der dargestellten Ausführung weist die Strommesszange eine Stromerfassungseinheit 1, eine Auswertungseinheit 2 und eine USB-Schnittstelle 3 auf. Darüber hinaus weist die Strommesszange einen geteilten Eisenkern 6 auf, welcher den Zangenkopf bildet und mit welchem ein zu überprüfender Stromleiter (nicht dargestellt) umfassbar ist.

Bekanntermaßen wird mithilfe des geteilten Eisenkerns 6 ein sich um den Stromleiter ausbildendes Magnetfeld erfasst.

Die Stromerfassungseinheit 1 ist vorliegend in einem Luftspalt (nicht dargestellt) des geteilten Eisenkerns 6 angeordnet und dazu in der Lage, aus dem erfassten Magnetfeld den jeweiligen Stromwert zu ermitteln.

Die Stromerfassungseinheit 1 weist gemäß der dargestellten Ausführungsform für Gleichstrommessungen ein Hall-Element auf.

Um neben einer Erfassung der Messwerte von Wechselströmen auch eine präzise Erfassung der Messwerten von Gleichströmen realisieren zu können, weist die Strommesszange vorliegend einen Spannungswandler 9 auf, welcher in die Energieverbindung 8 der Stromerfassungseinheit 1 eingebunden ist und welcher die, durch die USB-Schnittstelle 3 bereitgestellte Versorgungsspannung in eine stabilisierte Spannung umsetzt. Die stabilierte Spannung dient als Referenzspannung für das Hall-Element der Stromerfassungseinheit 1.

Im Ausführungsbeispiel wird die stabilisierte Spannung als als bipolare Spannung mit einem Spannungswert von +/- 5V bereitgestellt.

Der Spannungswandler 9, ist im hier gezeigten Ausführungsbeispiel als Hoch-Tief-Setzsteller ausgebildet.

Die durch die Stromerfassungseinheit 1 ermittelten Stromwerte werden vorliegend als Messwerte, insbesondere als analoge Messwerte, bereitgestellt und an die Auswertungseinheit 2 übertragen.

Hierzu ist die Auswertungseinheit 2 über eine Verbindung 7.1 mit der Stromerfassungseinheit 1 verbunden.

Die Auswertungseinheit 2 ist erfindungsgemäß dazu in der Lage, beispielsweise mittels eines A/D-Wandlers (nicht dargestellt), die übertragenen Messwerte in digitale Messwerte umzuwandeln und diese darüber hinaus als USB-kompatible Daten übertragbar bereitzustellen.

Die USB-kompatiblen Daten werden von der Auswertungseinheit 2 über eine weitere Verbindung 7.2 an die USB-Schnittstelle 3 übertragen.

Die USB-Schnittstelle 3 bildet erfindungsgemäß eine elektrisch/mechanische Verbindungseinheit, über welche eine externe Datenverarbeitungseinheit (nicht dargestellt), beispielsweise ein Laptop oder ein Smartphone, mit der Strommesszange verbindbar ist.

Während des Betriebs der Strommesszange können auf diese Weise, als besonderer Vorteil der Erfindung, die USB-kompatiblen Daten direkt von der Strommesszange auf die jeweils angeschlossene, externe Datenverarbeitungseinheit übertragen und auf dieser in der gewünschten Form weiterverarbeitet werden. Beispielsweise können so die ermittelten Stromwerte auf der externen Datenverarbeitungseinheit angezeigt und/oder für eine weitere Verwendung gespeichert werden.

Gleichzeitig ist durch die erfindungsgemäße USB-Schnittstelle 3 als weiterer technologischer Vorteil, je nach Anwendungsfall sowohl eine dauerhafte Energieversorgung der Auswertungseinheit 2, als auch, mittelbar über den Spannungswandler 9 eine dauerhafte Bereitstellung der Referenzspannung für die Stromerfassungseinheit 1 durch die angeschlossene, externe Datenverarbeitungseinheit bereitstellbar.

Hierzu ist die Auswertungseinheit 2 ebenfalls über die Energieverbindung 8 mit der USB-Schnittstelle 3 verbunden.

Vorliegend werden in diesem Zusammenhang über die USB-Schnittstelle 3 eine Spannung von ca. 5V und ein Strom von ≥ 100mA für die Auswertungseinheit 2 bereitgestellt.

Die erfindungsgemäße Strommesszange ermöglicht aufgrund der USB-Schnittstelle 3 ein universelles Anschließen an jede, USB-fähige Datenverarbeitungseinheit, wobei als besonderer Vorteil keine zusätzlichen Energiequellen, wie etwa Batterien, für die Strommesszange oder zusätzliche Anzeigegeräte zur Visualisierung der ermittelten Stromwerte vorgehalten werden müssen. Gegenüber herkömmlichen Strommesszangen ermöglicht die vorliegende Lösung somit zum einen eine universelle Anschließbarkeit und eine verbesserte Mobilität der erfindungsgemäßen Strommesszange und zum anderen eine präzise Erfassung der Messwerte von Gleichströmen.

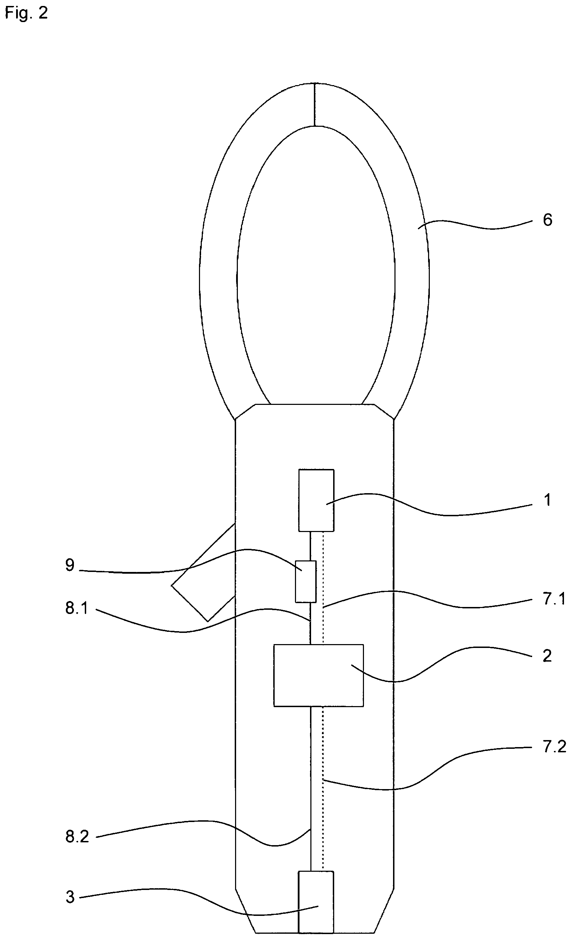

Fig. 2 zeigt eine Ausführungsform einer Strommesszange, bei welcher die Spannungsversorgung der Stromerfassungseinheit 1 mittebar über die Auswertungseinheit 2 erfolgt. Der Spannungswandler 9 zur Bereitstellung der Referenzspannung ist hierbei in die Energieverbindung 8.1 eingebunden.

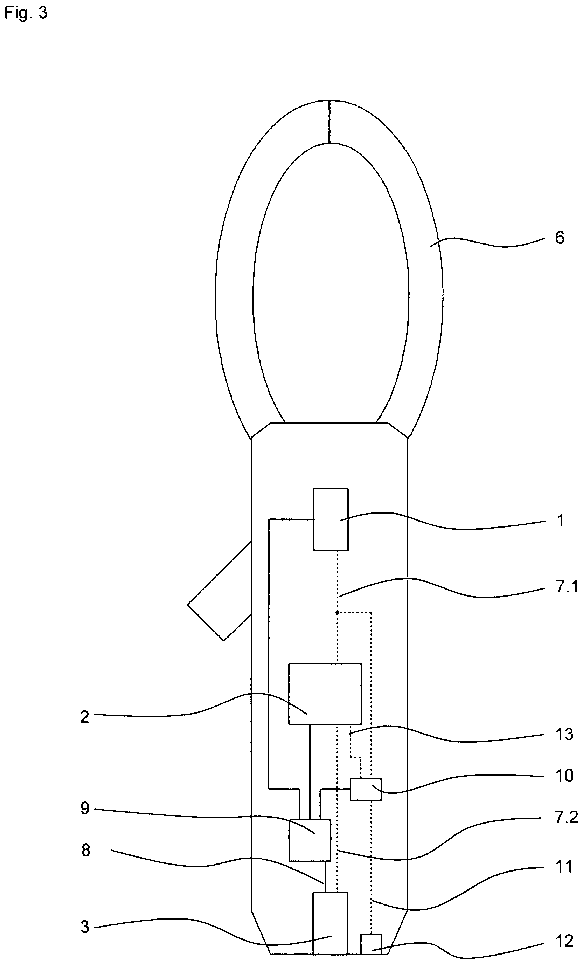

In Fig. 3 ist ein Ausführungsbeispiel der Strommesszange dargestellt, in welcher diese zusätzlich einen Analogausgang 12, insbesondere zum Anschluss an ein Oszilloskop (nicht dargestellt) aufweist.

Um entsprechende Analogsignale der erfassten Messwerte ausgeben zu können, weist die Strommesszange im vorliegenden Ausführungsbeispiel eine Signalaufbereitungseinheit 10 auf, welche dazu in der Lage ist, die Messwerte als analoge Signale zu erfassen und diese inbesondere mittels Spannungsverstärkung und Spannungsverschiebung zu Analogdaten aufzubereiten. Die Analogdaten sind anschließend über eine Analogverbindung 11 und den Analoganschluss 12 an das angeschlossene Oszilloskop übertragbar bereitstellbar.

Wie in Fig. 3 zudem dargestellt, ist der Spannungswandler 9 vorliegend so in die Energieverbindung 8 eingebunden, dass über dessen Ausgang sowohl eine stabilisierte Referenzspannung für die Stromerfassungseinheit 1, eine stabilisierte Versorgungspannung für die Auswertungseinheit 2, als auch eine bipolare Spannung für die Signalaufbereitungseinheit 10 verfügbar gemacht wird.

Wie Fig. 3 zeigt, wir in diesem Ausführungsbeispiel parallel eine digitale und analoge Messwertverarbeitung und -ausgabe durchgeführt.

In Fig. 3 wird die besondere Ausführungsform gezeigt, bei welcher die Auswertungseinheit 2 und die Signalaufbereitungseinheit 10 über eine Steuersignalverbindung 13 verbunden sind. Die Auswertungseinheit 2 ist hierbei dazu in der Lage, über einen integrierten D/A-Wandler (nicht dargestellt), ein analoges Steuersignal bereitzustellen und dieses über einen Steuersignalausgang (nicht dargestellt), die Steuersignalverbindung 13 und einen Steuersignaleingang (nicht dargestellt) der Signalaufbereitungseinheit 10 an die Signalaufbereitungseinheit zu übertragen.

Mittels eines solchen Steuersignals ist die Signalaufbereitungseinheit 10 vorliegend dazu in der Lage, eine Nullsetzung der Analogdaten und somit, beispielsweise vor Beginn eines Messvorgangs, eine Kalibrierung des Analogausgangs durchzuführen.

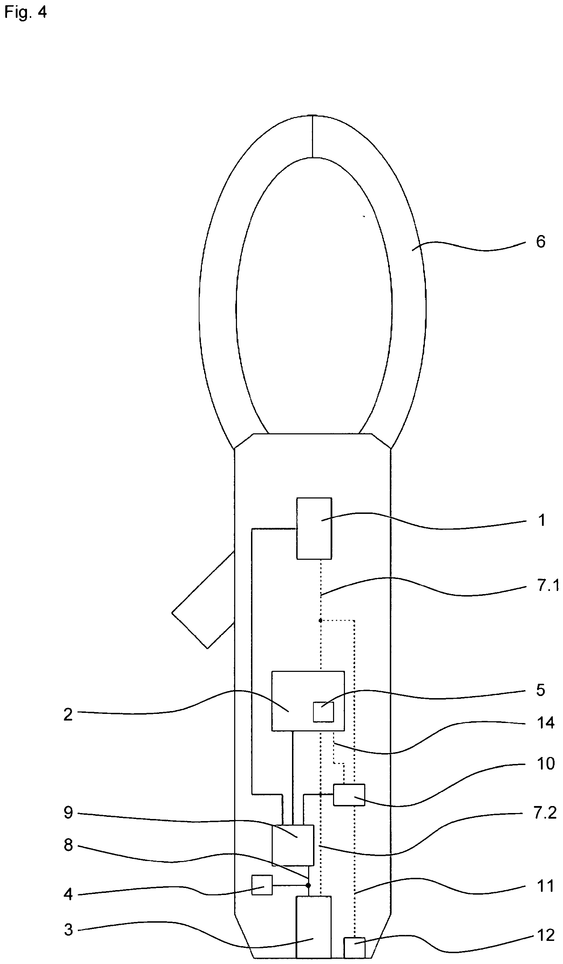

Ein weiteres Ausführungsbeispiel der Strommesszange ist in Fig. 4 dargestellt. Gegenüber der Variante gemäß Fig. 3 weist die Strommesszange vorliegend zusätzlich einen Energiepufferspeicher 4 und einen Datenspeicher 5 auf, wobei der Datenspeicher 5 der Auswertungseinheit 2 zugeordnet ist.

Der Energiepufferspeicher 4 ist im hier gezeigten Ausführungsbeispiel so in die Energieverbindung 8 eingebunden, dass dieser, während des Betriebes der Strommesszange, durch die überschüssige Energie, welche nicht für die Funktionsfähigkeit der Auswertungseinheit 2, der Stromerfassungseinheit 1 und der Signalaufbereitungseinheit 10 benötigt wird, geladen wird.

Hierdurch wird es als besonderer Vorteil ermöglicht, dass die notwendige Energie für den Betrieb der Strommesszange kurzzeitig durch den Energiepufferspeicher 4 bereitstellbar ist und die Strommesszange somit temporär autark, ohne angeschlossene Datenverarbeitungseinheit betreibbar ist.

Der Datenspeicher 5 ermöglicht vorliegend eine temporäre Zwischenspeicherung der ermittelten Messwerte, wobei vorliegend insbesondere die Messwerte, welche als USB-kompatible Daten auf dem Datenspeicher 5 hinterlegbar sind.

In diesem Zusammenhang kann der Datenspeicher 5 als Bestandteil der Auswertungseinheit 2 durch eine, an die USB-Schnittstelle 3 angeschlossene, externe Datenverarbeitungseinheit (nicht dargestellt) abgefragt und so die zwischengespeicherten Daten bei Bedarf abgerufen werden.

Die Integration des Energiepufferspeichers 4 und des Datenspeichers 5 bietet insbesondere den Vorteil, dass die Strommesszange vorübergehend auch autark, also ohne eine Verbindung zu einer externen Datenverarbeitungseinheit, betreibbar ist und so die Mobilität der Strommesszange zusätzlich verbessert werden kann.

### Verwendete Bezugszeichen

- 1: Stromerfassungseinheit
- 2: Auswertungseinheit
- 3: USB-Schnittstelle
- 4: Energiepufferspeicher
- 5: Datenspeicher
- 6: teilbarer Kern
- 7: Verbindung
- 8: Energieverbindung
- 9: Spannungswandler
- 10: Signalaufbereitungseinheit
- 11: Analogverbindung
- 12: Analogausgang
- 13: Steuersignalverbindung

## Patentansprüche

1. Strommesszange,
aufweisend eine Stromerfassungseinheit (1), eine Auswertungseinheit (2) und eine USB-Schnittstelle (3), wobei die Stromerfassungseinheit (1) eingerichtet ist, Stromwerte zu erfassen und die Stromwerte als Messwerte bereitzustellen,
und wobei die Auswertungseinheit (2) einen Analog-Digital-Wandler aufweist und mit der Stromerfassungseinheit (1) verbunden ist und wobei die Auswertungseinheit (2) eingerichtet ist, die Messwerte verarbeitbar als digitale und USB-kompatible Daten an die USB-Schnittstelle (3) zu übertragen, und wobei die USB-Schnittstelle (3) mit der Auswertungseinheit (2) verbunden ist und wobei die USB-Schnittstelle (3) eingerichtet ist, die USB-kompatiblen Daten für eine Weiterverarbeitung übertragbar bereitzustellen und eine Energieversorgung der Auswertungseinheit (2) bereitzustellen,
**dadurch gekennzeichnet,**
**dass** die Strommesszange einen Spannungswandler (9) aufweist, wobei die USB-Schnittstelle (3) eingerichtet ist, eine Energieversorgung des Spannungswandlers (9) bereitzustellen und wobei der Spannungswandler eingerichtet ist, eine stabilisierte Spannung als Referenzspannung für die Stromerfassungseinheit bereitzustellen,
**dass** die Strommesszange eine Signalaufbereitungseinheit (10) aufweist, welche mit der Stromerfassungseinheit (1) verbunden ist und welche eingerichtet ist, die Messwerte als analoge Signale zu erfassen und zu Analogdaten aufzubereiten, wobei die Signalaufbereitungseinheit (10) durch den Spannungswandler (9) mit einer bipolaren Spannung gespeist wird, und dass die Strommesszange einen Analogausgang (12) aufweist, wobei der Analogausgang (12) mit der Signalaufbereitungseinheit (10) verbunden ist und wobei der Analogausgang (12) eingerichtet ist, die Analogdaten auszugeben.

2. Strommesszange nach Anspruch 1,
**dadurch gekennzeichnet,**
**dass** die Stromerfassungseinheit (1) als intelligenter Messchip ausgebildet ist und dass die Stromerfassungseinheit (1) eingerichtet ist, erfasste Stromwerte aufzubereiten und die aufbereiteten Stromwerte als Messwerte übertragbar bereitzustellen.

3. Strommesszange nach Anspruch 1 oder 2,
**dadurch gekennzeichnet,**
**dass** diese einen Energiepufferspeicher (4) aufweist und dass die USB-Schnittstelle (3) eingerichtet ist, eine Energieversorgung des Energiepufferspeichers (4) bereitzustellen und dass der Energiepufferspeicher (4) eingerichtet ist, die Energieversorgung der Auswertungseinheit (2) bereitzustellen und dass die Strommesszange einen Datenspeicher (5) aufweist, wobei der Datenspeicher (5) eingerichtet ist, verarbeitete Messwerte zu speichern und übertragbar bereitzustellen.

4. Strommesszange nach einem der vorhergehenden Ansprüche,
**dadurch gekennzeichnet,**
**dass** die Auswertungseinheit (2) einen Steuersignalausgang aufweist und dass die Signalaufbereitungseinheit (10) einen Steuersignaleingang aufweist, wobei der Steuersignalausgang mit dem Steuersignaleingang über eine Steuersignalverbindung (13) verbunden ist, wobei die Auswertungseinheit (2) eingerichtet ist, ein Steuersignal bereitzustellen und an die Signalaufbereitungseinheit (10) zu übertragen und wobei die Signalaufbereitungseinheit (10) eingerichtet ist, mittels des Steuersignals eine Nullsetzung der Analogdaten auszuführen.

## Claims

1. A clip-on ammeter,
comprising a current measurement unit (1), an evaluation unit (2) and a USB interface (3), wherein current values can be recorded by the current measurement unit (1) and the current values can be provided as measurement values,
and wherein the evaluation unit (2) comprises an A/D converter and is connected to the current measurement unit (1) and wherein the evaluation unit (2) is capable to process the measurement values to digital and USB compatible data to be transferred to the USB interface (3), and wherein the USB interface (3) is connected to the evaluation unit (2) and wherein the USB compatible data can be provided by the USB interface (3) for transfer purposes to be further processed and wherein the evaluation unit (2) can be energized via the USB interface (3),
**characterized in that**
the clip-on ammeter comprises a voltage transformer (9), wherein energy can be supplied to the voltage transformer (9) via the USB interface (3) and wherein the voltage transformer (9) is capable to provide a stabilized voltage as a reference voltage for the current measurement unit (1), the clip-on ammeter comprises a signal processing unit (10), which is connected to the current measurement unit (1) and which is capable to record the measurement values as signals and to process them to analog data, wherein the signal processing unit (10) is powered with a bipolar voltage by the voltage transformer (9), and that the clip-on ammeter comprises an analog output (12), wherein the analog output (12) is connected to the signal processing unit (10) and wherein the analog data can be output via the analog output (12).

2. The clip-on ammeter according to claim 1,
**characterized in that**
the current measurement unit (1) is designed as an intelligent measurement chip and that the current measurement unit (1) is capable to process the current values measured and to provide the current values processed as measurement values for transfer purposes.

3. The clip-on ammeter according to claim 1 or 2,
**characterized in that**
it comprises an energy buffer storage (4) and that the energy buffer storage (4) can be energized via the USB interface (3) and that the energy supply for the evaluation (2) unit can be provided by the energy buffer storage (4), and that the clip-on ammeter comprises a data storage (5), wherein the data storage (5) is capable to store the measurement values processed and to provide them for transfer purposes.

4. The clip-on ammeter according to any of the previous claims,
**characterized in that**
the evaluation unit (2) comprises a control signal output and that the signal processing unit (10) comprises a control signal input, wherein the control signal output is connected with the control signal input via a control signal connection line (13), wherein a control signal can be provided by the evaluation unit (2) and transferred to the signal processing unit (10) and wherein, on the basis of the control signal, the signal processing unit (10) can set the analog data to zero.

## Revendications

1. Pince ampérométrique,
comportant une unité (1) de détection du courant, une unité (2) d'analyse et une interface (3) USB, dans laquelle l'unité (1) de détection du courant est agencée pour détecter des valeurs de courant et pour mettre les valeurs de courant sous la forme de valeurs de mesure,
et dans laquelle l'unité (2) d'analyse a un convertisseur analogique-numérique et est reliée à l'unité (1) de détection du courant, et dans laquelle l'unité (2) d'analyse est agencée pour transmettre à l'interface (3) USB des valeurs de mesure pouvant être traitées en données numériques et compatibles USB, et dans laquelle l'interface (3) USB est reliée à l'unité (2) d'analyse, et dans laquelle l'interface (3) USB est agencée pour mettre les données compatibles (USB) à disposition d'un traitement ultérieur avec possibilité de transmission et pour mettre une alimentation en énergie électrique à disposition de l'unité (2) d'analyse,
**caractérisée**
**en ce que** la pince ampérométrique a un transformateur (9) de tension, dans laquelle l'interface (3) USB est agencée pour mettre une alimentation en énergie électrique à la disposition du transformateur (9) de tension, et dans laquelle le transformateur de tension est agencé pour mettre une tension stabilisée comme tension de référence à disposition de l'unité de détection du courant,
**en ce que** la pince ampérométrique a une unité (10) de traitement du signal, qui est reliée à l'unité (1) de détection du courant et qui est agencée pour détecter les valeurs de mesure sous la forme de signaux analogiques et pour disposer de données analogiques, dans laquelle l'unité (10) de traitement du signal est alimentée en une tension bipolaire par le transformateur (9) de tension et en ce que la pince ampérométrique a une sortie (12) analogique, dans laquelle la sortie (12) analogique est reliée à l'unité (10) de traitement du signal, et dans laquelle la sortie (12) analogique est agencée pour donner des données analogiques.

2. Pince ampérométrique suivant la revendication 1,
**caractérisée**
**en ce que** l'unité (1) de détection du courant est constituée sous la forme d'une puce de mesure intelligente, et en ce que l'unité (1) de détection du courant est agencée pour traiter des valeurs de courant détectées et mettre les valeurs de courant traitées à disposition, avec possibilité de transmission, comme valeurs de mesure.

3. Pince ampérométrique suivant la revendication 1 ou 2,
**caractérisée**
**en ce que** celle-ci a une mémoire (4) tampon d'énergie et en ce que l'interface (3) USB est agencée pour mettre une alimentation en énergie électrique à disposition de la mémoire (4) tampon d'énergie et en ce que la mémoire (4) tampon d'énergie est agencée pour mettre l'alimentation en énergie à disposition de l'unité (2) d'analyse et en ce que la pince ampérométrique a une mémoire (5) de données, dans laquelle la mémoire (5) de données est agencée pour mettre en mémoire des valeurs de mesure traitées et les mettre à disposition avec possibilité de transmission.

4. Pince ampérométrique suivant l'une des revendications précédentes,
**caractérisée**
**en ce que** l'unité (2) d'analyse a une sortie de signal de commande et en ce que l'unité (10) de traitement du signal a une entrée de signal de commande, dans laquelle la sortie du signal de commande est reliée à l'entrée du signal de commande par une liaison (13) de signal de commande, dans laquelle l'unité (2) d'analyse est agencée pour disposer d'un signal de commande et le transmettre à l'unité (10) de traitement du signal, et dans laquelle l'unité (10) de traitement du signal est agencée pour exécuter, au moyen du signal de commande, une mise à zéro des données analogiques.
